(19) Europäisches Patentamt
European Patent Office
Office européen des brevets

(11) **EP 4 394 904 A1**

(12) **EUROPEAN PATENT APPLICATION**

(43) Date of publication:
**03.07.2024 Bulletin 2024/27**

(21) Application number: **23219119.7**

(22) Date of filing: **21.12.2023**

(51) International Patent Classification (IPC):
***H01L 33/44*** *(2010.01)*         ***H01L 33/56*** *(2010.01)*

(52) Cooperative Patent Classification (CPC):
**H01L 33/44; H01L 33/56**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **28.12.2022 KR 20220187751**

(71) Applicant: **Samsung Electronics Co., Ltd.**
**Suwon-si, Gyeonggi-do 16677 (KR)**

(72) Inventor: **KIM, Jungsung**
**16677 Suwon-si, Gyeonggi-do (KR)**

(74) Representative: **Kuhnen & Wacker**
**Patent- und Rechtsanwaltsbüro PartG mbB**
**Prinz-Ludwig-Straße 40A**
**85354 Freising (DE)**

(54) **SEMICONDUCTOR LIGHT EMITTING DEVICE**

(57)     A semiconductor light emitting device, including a light emitting structure comprising a first semiconductor layer having a first conductivity type, a second semiconductor layer having a second conductivity type which is different from the first conductivity type, and an active layer between the first semiconductor layer and the second semiconductor layer and configured to emit light having a wavelength in a range of about 620 nm to about 750 nm; a first electrode electrically connected to the first semiconductor layer; a second electrode electrically connected to the second semiconductor layer; a capping layer on a top surface of the light emitting structure and having a first refractive index in a range of about 2.05 to about 2.58; and an encapsulation layer on the capping layer and on the light emitting structure, and having a second refractive index which is less than the first refractive index.

FIG. 1

**Description**

CROSS-REFERENCE TO RELATED APPLICATION

This application is based on and claims priority to Korean Patent Application No. 10-2022-0187751, filed on December 28, 2022, in the Korean Intellectual Property Office, the disclosure of which is incorporated by reference herein in its entirety.

BACKGROUND

1. Field

Embodiments relate to a semiconductor light emitting device, and more particularly, to a semiconductor light emitting device configured to emit light in a red wavelength range.

2. Description of Related Art

Semiconductor light emitting devices may be used as light sources for lighting devices or light sources for display devices. For example, semiconductor light emitting devices may emit light in a specific wavelength range to be used in various applications, for example, as horticultural lighting. There is a need for improved efficiency or performance of a package using such a semiconductor light emitting device.

SUMMARY

Provided is a semiconductor light emitting device configured to emit light in a red wavelength range, and having improved light extraction efficiency.
Additional aspects will be set forth in part in the description which follows and, in part, will be apparent from the description, or may be learned by practice of the presented embodiments.
In accordance with an aspect of the disclosure, a semiconductor light emitting device includes: a light emitting structure comprising a first semiconductor layer having a first conductivity type, a second semiconductor layer having a second conductivity type which is different from the first conductivity type, and an active layer between the first semiconductor layer and the second semiconductor layer and configured to emit light having a wavelength in a range of about 620 nm to about 750 nm; a first electrode electrically connected to the first semiconductor layer; a second electrode electrically connected to the second semiconductor layer; a capping layer on a top surface of the light emitting structure and having a first refractive index in a range of about 2.05 to about 2.58; and an encapsulation layer on the capping layer and on the light emitting structure, and having a second refractive index which is less than the first refractive index.
In accordance with an aspect of the disclosure, a semiconductor light emitting device includes a light emitting structure comprising a first semiconductor layer having a first conductivity type which is different from the first conductivity type, a second semiconductor layer having a second conductivity type, and an active layer between the first semiconductor layer and the second semiconductor layer and configured to emit light having a wavelength in a range of about 620 nm to about 750 nm; a first electrode electrically connected to the first semiconductor layer; a second electrode electrically connected to the second semiconductor layer; a capping layer on a top surface of the light emitting structure, having a first refractive index in a range of about 2.05 to about 2.58, wherein a thickness of the capping layer is in a range of about 50 nm to about 100 nm; and an encapsulation layer on the capping layer and on the light emitting structure, and having a second refractive index which is less than the first refractive index, wherein the capping layer is directly on a top surface of the second semiconductor layer, and wherein the second semiconductor layer has a third refractive index which is greater than the first refractive index.
In accordance with an aspect of the disclosure, a semiconductor light emitting device includes: a housing; a light emitting structure on a top surface of the housing, comprising a first semiconductor layer having a first conductivity type, a second semiconductor layer having a second conductivity type which is different from the first conductivity type, and an active layer between the first semiconductor layer and the second semiconductor layer, and configured to emit light having a wavelength in a range of about 620 nm to about 750 nm; a first electrode electrically connected to the first semiconductor layer; a second electrode electrically connected to the second semiconductor layer; a capping layer on a top surface of the light emitting structure and having a first refractive index in a range of about 2.05 to about 2.58; a reflective layer on side surfaces of the light emitting structure on the top surface of the housing; and an encapsulation layer on the light emitting structure on the capping layer and the reflective layer, and having a second refractive index which is less than the first refractive index.

BRIEF DESCRIPTION OF DRAWINGS

The above and other aspects, features, and advantages of certain embodiments of the present disclosure will be more apparent from the following description taken in conjunction with the accompanying drawings, in which:

FIG. 1 is a cross-sectional view illustrating a semiconductor light emitting device according to an embodiment;

FIG. 2 is an enlarged view of a portion A of FIG. 1 according to an embodiment;

FIG. 3 is a table illustrating a material of a capping layer and a refractive index corresponding thereto according to embodiments;

FIGS. 4A and 4B are simulation graphs illustrating transmittance of a semiconductor light emitting device according to embodiments;

FIG. 5 is a simulation graph illustrating transmittance of a semiconductor light emitting device according to an embodiment;

FIG. 6 is a cross-sectional view illustrating a semiconductor light emitting device according to an embodiment;

FIG. 7 is a cross-sectional view illustrating a semiconductor light emitting device according to an embodiment;

FIG. 8 is a cross-sectional view illustrating a semiconductor light emitting device according to an embodiment;

FIG. 9 is a cross-sectional view illustrating a semiconductor light emitting device according to an embodiment;

FIG. 10 is a perspective view schematically illustrating a flat panel lighting device including a semiconductor light emitting device according to an embodiment;

FIG. 11 is an exploded perspective view schematically illustrating a lighting device including a semiconductor light emitting device according to an embodiment;

FIG. 12 is an exploded perspective view schematically illustrating a bar type lighting device including a semiconductor light emitting device according to an embodiment;

FIG. 13 is an exploded perspective view schematically illustrating a lighting device including a semiconductor light emitting device according to an embodiment;

FIG. 14 is a schematic diagram illustrating an indoor lighting control network system including a semiconductor light emitting device according to an embodiment; and

FIG. 15 is a schematic diagram illustrating a network system including a semiconductor light emitting device according to an embodiment.

DETAILED DESCRIPTION OF EMBODIMENTS

Hereinafter, embodiments are described in detail with reference to the accompanying drawings. Like numeral references may generally refer to like elements throughout the description.

It will be understood that when an element or layer is referred to as being "over," "above," "on," "below," "under," "beneath," "connected to" or "coupled to" another element or layer, it can be directly over, above, on, below, under, beneath, connected or coupled to the other element or layer or intervening elements or layers may be present. In contrast, when an element is referred to as being "directly over," "directly above," "directly on," "directly below," "directly under," "directly beneath," "directly connected to" or "directly coupled to" another element or layer, there are no intervening elements or layers present.

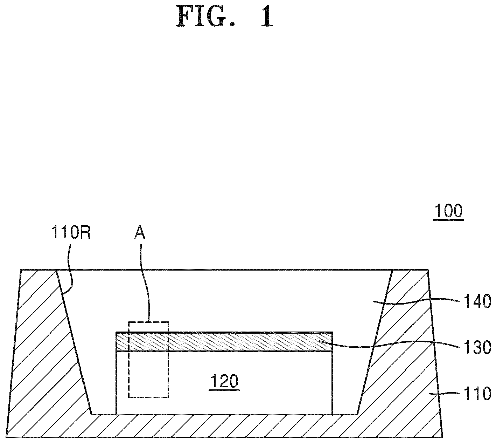

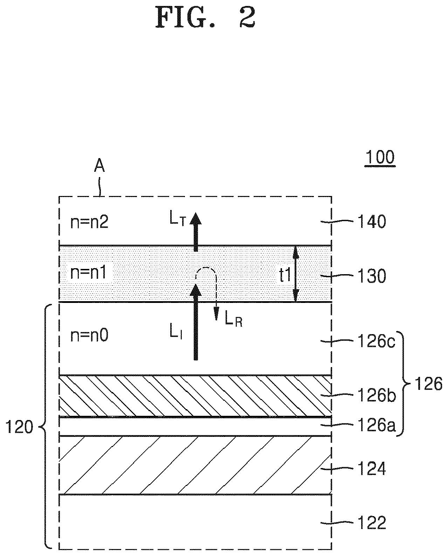

FIG. 1 is a cross-sectional view illustrating a semiconductor light emitting device 100 according to embodiments. FIG. 2 is an enlarged view of a portion A of FIG. 1.

Referring to FIGS. 1 and 2, the semiconductor light emitting device 100 may include a housing 110, a light emitting structure 120, a capping layer 130, and an encapsulation layer 140.

The housing 110 may include a light emitting structure mounting region 110R defined on a top surface of the housing 110. For example, the housing 110 may have a cup shape, and the light emitting structure mounting region 110R may be formed in the cup shape. In embodiments, the housing 110 may include a silicone resin or an epoxy resin including metal powder having high reflectivity or ceramic powder having high reflectivity.

In embodiments, the housing 110 may have a cup shape including a base portion and a sidewall portion extending upward from the base portion. The light emitting structure mounting region 110R may have a shape defined by a top surface of the base portion and a sidewall portion inclined at an inclination angle from the base portion, and the sidewall portion may be inclined so that a width of the light emitting structure mounting region 110R increases as a distance from the top surface of the base portion increases.

In embodiments, the housing 110 may include only a base portion having a flat top surface, and a light emitting structure mounting region 110R may be defined on the top surface of the housing 110.

The light emitting structure 120 may be mounted on the top surface of the housing 110. The light emitting structure 120 may include a first semiconductor layer 122, an active layer 124, and a second semiconductor layer 126. In embodiments, the first semiconductor layer 122 may have a first conductivity type, and the second semiconductor layer 126 may have a second conductivity type different from the first conductivity type. As illustrated in FIG. 2, the first semiconductor layer 122 and the second semiconductor layer 126 may be stacked with the active layer 124 therebetween. In addition, the first semiconductor layer 122 may be arranged on the top surface of the housing 110, and the active layer 124 and the second semiconductor layer 126 may be sequentially arranged on the first semiconductor layer 122. In embodiments, a buffer structure or a portion of a growth substrate may be further arranged between the first semiconductor layer 122 and the housing 110.

Hereinafter, a surface of the first semiconductor layer 122 in contact with the top surface of the housing 110 may be referred to as a bottom surface of the first semiconductor layer 122, and a surface of the second semiconductor layer 126 farthest from the first semiconductor layer 122 may be referred to as a top surface of the second semiconductor layer 126.

The light emitting structure 120 may emit light having a wavelength which is in a red wavelength range. In embodiments, the light having the wavelength in the red wavelength range may be referred to as light in the red wavelength range. For example, the light emitted by the light emitting structure 120 toward a top of the housing 110 may be red light having a wavelength in a range of about 620 nanometers (nm) to about 750 nm.

The first semiconductor layer 122 may include a p-type semiconductor layer. For example, the first semiconductor layer 122 may include a compound semiconductor material having a chemical formula of $Al_xGa_yIn_{1-x-y}P$ (where $0 \leq x \leq 1$, $0 \leq y \leq 1$, and $0 \leq x+y \leq 1$). For example, the first semiconductor layer 122 may include at least one of p-type doped AlInP, GaInP, AlGaInP, AlP, GaP, and InP. The first semiconductor layer 122 may include a p-type dopant, and the p-type dopant may include at least one of magnesium (Mg), zinc (Zn), calcium (Ca), selenium (Se), and barium (Ba). In some embodiments, the first semiconductor layer 122 may include AlInP.

For example, the first semiconductor layer 122 may have a single layer structure. In other embodiments, the first semiconductor layer 122 may have a multilayer structure having different compositions. For example, the first semiconductor layer 122 may include an electronic blocking layer (EBL), a low-concentration p-type semiconductor layer, and a high-concentration p-type semiconductor layer sequentially stacked in a first direction. For example, the EBL may have a structure in which a plurality of $Al_xGa_yIn_{1-x-y}P$ material layers of different compositions each having a thickness in a range of about 5 nm to about 100 nm are stacked, or may include a single layer including $Al_xGa_yIn_{1-x-y}P$. An energy band gap Eg of the EBL may decrease as a distance from the active layer 124 increases. For example, the Al composition of the EBL may decrease as the distance from the active layer 124 increases.

In embodiments, the second semiconductor layer 126 may include a cladding layer 126a, a current diffusion layer 126b, and a contact semiconductor layer 126c. For example, the cladding layer 126a, the current diffusion layer 126b, and the contact semiconductor layer 126c may be sequentially arranged on a top surface of the active layer 124.

In embodiments, the cladding layer 126a may include a compound semiconductor material having a chemical formula of $Al_xGa_yIn_{1-x-y}P$ (where $0 \leq x \leq 1$, $0 \leq y \leq 1$, and $0 \leq x+y \leq 1$). For example, the cladding layer 126a may include AlInP.

In embodiments, the current diffusion layer 126b may include an n-type superlattice layer. In some embodiments, the current diffusion layer 126b may have a structure in which a first material layer having a first composition of $Al_xGa_yIn_{1-x-y}P$ (where $0 \leq x \leq 1$, $0 \leq y \leq 1$, and $0 \leq x+y \leq 1$), and a second material layer having a second composition of $Al_xGa_yIn_{1-x-y}P$ (where $0 \leq x \leq 1$, $0 \leq y \leq 1$, and $0 \leq x+y \leq 1$) are alternatingly and repeatedly stacked. In some embodiments, the current diffusion layer 126b may have a structure in which the first material layer having the first composition of $Al_xGa_yIn_{1-x-y}P$ (where $0 \leq x \leq 1$, $0 \leq y \leq 1$, and $0 \leq x+y \leq 1$) and a first impurity concentration, and the second material layer having the second composition of $Al_xGa_yIn_{1-x-y}P$ (where $0 \leq x \leq 1$, $0 \leq y \leq 1$, and $0 \leq x+y \leq 1$) and a second impurity concentration are alternatingly and repeatedly stacked. Each of the first material layer and the second material layer may have a thickness in a range of about 1 nm to about 500 nm. In embodiments, an impurity concentration of the current diffusion layer 126b may be in a range of about $2 \times 10^{18}$ per cubic centimeter ($cm^{-3}$) to about $9 \times 10^{19}$ $cm^{-3}$.

In some embodiments, the contact semiconductor layer 126c may include a compound semiconductor material having a chemical formula of $Al_xGa_yIn_{1-x-y}P$ (where $0\leq x\leq1$, $0\leq y\leq1$, and $0\leq x+y\leq1$). For example, the contact semiconductor layer 126c may include AlGaInP. An impurity concentration of the contact semiconductor layer 126c may be in a range of about $2\times10^{18}$ cm$^{-3}$ to about $9\times10^{19}$ cm$^{-3}$, and a thickness of the contact semiconductor layer 126c may be about 5 micrometers ($\mu$m) or less.

In some embodiments, the second semiconductor layer 126 may include a compound semiconductor represented by the chemical formula AlGaInP. For example, at least one of the cladding layer 126a, the current diffusion layer 126b, and the contact semiconductor layer 126c may include an AlGaInP material. In some embodiments, a wavelength of light emitted by the light emitting structure 120 may be in a range of, for example, about 620 nm to about 700 nm, about 640 nm to about 680 nm, or about 650 nm to about 670 nm. For example, a nominal wavelength (or a target wavelength or a center wavelength) of the light emitted by the light emitting structure 120 may be about 660 nm. In other embodiments, a wavelength of the light emitted by the light emitting structure 120 may be in a range of, for example, about 680 nm to about 750 nm, about 700 nm to about 750 nm, or about 720 nm to about 740 nm. For example, the nominal wavelength (or the target wavelength or the center wavelength) of the light emitted by the light emitting structure 120 may be about 730 nm.

In other embodiments, the second semiconductor layer 126 may include a compound semiconductor represented by the chemical formula AlGaAs. For example, at least one of the cladding layer 126a, the current diffusion layer 126b, and the contact semiconductor layer 126c may include an AlGaAs material. For example, at least one of the cladding layer 126a, the current diffusion layer 126b, and the contact semiconductor layer 126c may include a compound semiconductor material having a chemical formula of $Al_xGa_{1-x}As$ ($0\leq x\leq1$). In embodiments, the wavelength of the light emitted by the light emitting structure 120 may be in a range of, for example, about 680 nm to about 750 nm, about 700 nm to about 750 nm, or about 720 nm to about 740 nm. For example, the nominal wavelength (which may be referred to as the target wavelength and the center wavelength) of the light emitted by the light emitting structure 120 may be about 730 nm.

In embodiments, the active layer 124 may have a multi-quantum well (MQW) structure in which a quantum well layer and a quantum barrier layer are alternately stacked. In some embodiments, the quantum well layer and the quantum barrier layer may include $Al_xGa_yIn_{1-x-y}P$ (where $0\leq x\leq1$, $0\leq y\leq1$, and $0\leq x+y\leq1$) material layers having different compositions. In some embodiments, the quantum well layer may include an AlGaInP material layer, and the quantum barrier layer may include an AlGaInP material layer. In some embodiments, the quantum well layer may include an AlInP material layer, and the quantum barrier layer may include an AlGaInP material layer. In other embodiments, the quantum well layer and the quantum barrier layer may include $Al_xGa_{1-x}As$ ($0\leq x\leq1$) material layers having different compositions. In some embodiments, the quantum well layer may include a GaAs material layer, and the quantum barrier layer may include an AlGaAs material layer. In embodiments, each of the quantum well layer and the quantum barrier layer may have a thickness in a range of about 1 nm to about 50 nm. In other embodiments, the active layer 124 may have a single quantum well structure.

The light emitting structure 120 may be arranged so that the second semiconductor layer 126 faces toward the top of the housing 110 to emit the light in the red wavelength range through the second semiconductor layer 126. In embodiments, red light having a wavelength in a range such as about 620 nm to about 750 nm, for example, red light having a wavelength in a range of about 640 nm to about 690 nm, or red light having a wavelength in a range of about 650 to about 670 nm, may be emitted by the light emitting structure 120 toward the top of the housing 110.

The capping layer 130 may be arranged on the light emitting structure 120. A refractive index n of the capping layer 130 may be a first refractive index n1 in a range of about 2.05 to about 2.58, and the capping layer 130 may have a thickness t1 in a range of about 50 nm to about 100 nm. The capping layer 130 may be arranged on the top surface of the second semiconductor layer 126 and may increase transmittance of light transmitted from the second semiconductor layer 126 toward the encapsulation layer 140. The capping layer 130 may increase transmittance by preventing reflection of red light at an interface, for example when the light in the red wavelength range is transmitted toward the encapsulation layer 140.

In embodiments, the capping layer 130 may include at least one of silver bromide (AgBr), thallium bromide (TlBr), carbon (C), thallium chloride (TlCl), cobalt (Co), bismuth germanate ($Bi_{12}GeO_{20}$), bismuth germanate ($Bi_4Ge_3O_{12}$), lead germanate ($Pb_5Ge_3O_{11}$), magnesium hydroxide ($MgH_2$), titanium hydroxide ($TiH_2$), lutetium (Lu), manganese (Mn), lead molybdic acid ($PbMoO_4$), aluminum nitride (AlN), boron nitride (BN), gallium nitride (GaN), silicon nitride ($Si_3N_4$), vanadium nitride (VN), potassium niobate ($KNbO_3$), lithium niobate ($LiNbO_3$), molybdenum trioxide (MoOs), niobium pentoxide ($Nb_2O_5$), tantalum pentoxide ($Ta_2O_5$), tellurium dioxide ($TeO_2$), titanium oxide ($TiO_2$), zirconium oxide ($ZrO_2$), silver gallium sulfide ($AgGaS_2$), arsenic trisulfide ($As_2S_3$), barium gallium sulfide ($BaGaS_7$), cadmium sulfide (CdS), cadmium gallium sulfide ($CdGa_2S_4$), mercury gallium sulfide ($HgGa_2S_4$), zinc sulfide (ZnS), zinc selenium (ZnSe), bismuth silicate ($Bi_{12}SiO_{20}$), potassium tantalate ($KTaO_3$), barium titanate ($BaTiO_3$), and strontium titanate ($SrTiO_3$).

In embodiments, the encapsulation layer 140 may be arranged on or cover the light emitting structure 120, which may be on the capping layer 130. The encapsulation layer 140 may be arranged in the light emitting structure mounting region 110R and may be arranged on or cover a top surface of the capping layer 130 and side walls of the light emitting structure 120.

The encapsulation layer 140 may include a silicone resin, may prevent moisture from penetrating the light emitting structure 120, and/or may protect the light emitting structure 120 against mechanical shocks, by acting for example as a protection layer. In embodiments, the encapsulation layer 140 may not include a phosphor.

In embodiments, a refractive index n of the encapsulation layer 140 may be a second refractive index $n2$, and the second refractive index $n2$ may be in a range of about 1.35 to about 1.60. For example, the second refractive index $n2$ of the encapsulation layer 140 may be less than the first refractive index $n1$ of the capping layer 130 (e.g., the first refractive index $n1$ in the range of about 2.05 to about 2.58). For example, a difference between the first refractive index $n1$ of the capping layer 130 and the second refractive index $n2$ of the encapsulation layer 140 may be in a range of about 0.5 to about 1.2.

A first electrode electrically connected to the first semiconductor layer 122 and a second electrode electrically connected to the second semiconductor layer 126 may be further provided on the light emitting structure 120. The first electrode and the second electrode may be further connected to a wiring structure formed on and/or in the housing 110.

As illustrated in FIG. 2, the capping layer 130 may be arranged between the second semiconductor layer 126 and the encapsulation layer 140, and the first refractive index $n1$ of the capping layer 130 may be determined to minimize reflection of red light at an interface between the second semiconductor layer 126 and the capping layer 130, and an interface between the capping layer 130 and the encapsulation layer 140. For example, the first refractive index $n1$ may be determined by considering transmittance at different interfaces of materials having the second refractive index $n2$ and a third refractive index $n0$ of the second semiconductor layer 126 (for example the contact semiconductor layer 126c). Accordingly, as illustrated in FIG. 2, with respect to incident light $L_I$ incident from the second semiconductor layer 126 to the capping layer 130, a ratio of transmitted light $L_T$ transmitted to the encapsulation layer 140 through the capping layer 130 may be maximized and a ratio of reflected light $L_R$ reflected back to the second semiconductor layer 126 through the capping layer 130 may be minimized. In other words, a ratio of the transmitted light $L_T$ to the incident light $L_I$ may be maximized, and a ratio of the reflected light $L_R$ to the incident light $L_I$ may be minimized.

In embodiments, the first refractive index $n1$ of the capping layer 130 may be less than the third refractive index $n0$ of the second semiconductor layer 126 and greater than the second refractive index $n2$ of the encapsulation layer 140. For example, the first refractive index $n1$ of the capping layer 130 may be determined based on the second refractive index $n2$ of the encapsulation layer 140 and the third refractive index $n0$ of the second semiconductor layer 126 using the following Equation (1).

$$n1 = \sqrt{n0 \times n2} \qquad (1)$$

In Equation (1) above, $n0$ may denote the refractive index of the second semiconductor layer 126, $n1$ may denote the refractive index of the capping layer 130, and $n2$ may denote the refractive index of the encapsulation layer 140.

In some embodiments, the third refractive index $n0$ of the second semiconductor layer 126 may be in a range of about 3.45 to about 3.55, the second refractive index $n2$ of the encapsulation layer 140 may be in a range of about 1.35 to about 1.60, and the first refractive index $n1$ of the capping layer 130 may be in a range of about 2.05 to about 2.53. In some embodiments, the third refractive index $n0$ of the second semiconductor layer 126 may be in a range of about 3.45 to about 3.55, the second refractive index $n2$ of the encapsulation layer 140 may be in a range of about 1.35 to about 1.60, and the first refractive index $n1$ of the capping layer 130 may be in a range of about 2.12 to about 2.43.

In other embodiments, the third refractive index $n0$ of the second semiconductor layer 126 may be in a range of about 3.60 to about 3.70, the second refractive index $n2$ of the encapsulation layer 140 may be in a range of about 1.35 to about 1.60, and the first refractive index $n1$ of the capping layer 130 may be in a range of about 2.07 to about 2.58. In other embodiments, the third refractive index $n0$ of the second semiconductor layer 126 may be in a range of about 3.60 to about 3.70, the second refractive index $n2$ of the encapsulation layer 140 may be in a range of about 1.35 to about 1.60, and the first refractive index $n1$ of the capping layer 130 may be in a range of about 2.17 to about 2.48.

For example, as illustrated in FIG. 2, in order to maximize the ratio of the transmitted light $L_T$ transmitted to the encapsulation layer 140 through the capping layer 130 with respect to the incident light $L_I$ incident from the second semiconductor layer 126 to the capping layer 130, and to minimize the ratio of the reflected light $L_R$ reflected back to the second semiconductor layer 126 through the capping layer 130 with respect to the incident light $L_I$ incident from the second semiconductor layer 126 to the capping layer 130, the first refractive index $n1$ may be determined by considering the transmittance at the different interfaces of the materials having the second refractive index $n2$ and the third refractive index $n0$.

In embodiments, a first thickness $t1$ of the capping layer 130 may be determined to maximize transmission efficiency of light emitted from the second semiconductor layer 126 to the encapsulation layer 140 through the capping layer 130. For example, as illustrated in FIG. 2, in order to maximize the ratio of the transmitted light $L_T$ transmitted to the encapsulation layer 140 through the capping layer 130 with respect to the incident light $L_I$ incident from the second semiconductor layer 126 to the capping layer 130, and to minimize the ratio of the reflected light $L_R$ reflected back to the second semiconductor layer 126 through the capping layer 130 with respect to the incident light $L_I$ incident from the second semiconductor layer 126 to the capping layer 130, the first thickness t1 of the capping layer 130 may be determined by considering transmittance at different interfaces of materials having the first refractive index n1, the second refractive index n2, and the third refractive index n0.

In embodiments, the first thickness t1 of the capping layer 130 may be determined to maximize the transmission efficiency of the light emitted to the encapsulation layer 140 through the capping layer 130 by making the reflected light at the interface between the second semiconductor layer 126 and the capping layer 130 interfere with the reflected light at the interface between the capping layer 130 and the encapsulation layer 140.. For example, the first thickness t1 of the capping layer 130 may be determined such that the reflected light at the interface between the second semiconductor layer 126 and the capping layer 130 is in antiphase with the reflected light at the interface between the capping layer 130 and the encapsulation layer 140. In embodiments, the first thickness t1 of the capping layer 130 may be determined based on a target thickness of the capping layer 130 according to the following Equation (2), and may be in a range of, for example, about 50 nm to about 100 nm.

$$t_{TG} = \frac{L_{TG}}{4 \times n1} \qquad (2)$$

In Equation 2, $t_{TG}$ may denote the target thickness of the capping layer, $L_{TG}$ may denote a target wavelength of the light emitted by the light emitting structure, and n1 may denote the refractive index of the capping layer.

In embodiments, the target thickness and material of the capping layer may be determined by considering the refractive index of the light emitting structure (for example, the refractive index of the second semiconductor layer 126) and the target wavelength of the light emitted by the light emitting structure and the target thickness and refractive index of the capping layer may be classified into Groups 1 to 3 below.

[TABLE 1]

| | Group 1 | | Group 2 | | Group 3 | |
|---|---|---|---|---|---|---|
| Target wavelength of light [nm] | 660 nm | | 730 nm | | 730 nm | |
| Second semiconductor layer material | AlGaInP | | AlGaInP | | AlGaAs | |
| Refractive index of the second semiconductor layer | 3.44 ~ 3.54 | | 3.44 ~ 3.54 | | 3.60 ~ 3.70 | |
| Refractive index of encapsulation layer | 1.35 ~ 1.60 | | 1.35 ~ 1.60 | | 1.35 ~ 1.60 | |
| | 1.41 | 1.55 | 1.41 | 1.55 | 1.41 | 1.55 |
| Target refractive index of capping layer | 2.22 | 2.33 | 2.22 | 2.33 | 2.27 | 2.38 |
| Refractive index of capping layer | 2.05~2.42 | 2.13~2.53 | 2.05~2.42 | 2.13~2.53 | 2.07~2.47 | 2.18~2.58 |
| Target thickness of capping layer [nm] | 50 ~ 95 | | 55 ~ 100 | | 55 ~ 100 | |

In some embodiments included in Group 1, the second semiconductor layer 126 may include an AlGaInP material, the third refractive index n0 may be in a range of about 3.45 to about 3.55, the second refractive index n2 of the encapsulation layer 140 may be in a range of about 1.35 to about 1.60, and the first refractive index n1 of the capping layer 130 may be in a range of about 2.05 to about 2.53. For example, based on the refractive index of the encapsulation layer 140 being 1.41, the target refractive index of the capping layer 130 may be 2.22, and in some embodiments, the capping layer 130 may have a refractive index in a range of about 2.05 to about 2.42, and the capping layer 130 may have a refractive index in a range of about 2.12 to about 2.32. In addition, based on the refractive index of the encapsulation layer 140 being 1.55, the target refractive index of the capping layer 130 may be 2.33, and in some embodiments, the capping layer 130 may have a refractive index in a range of about 2.13 to about 2.53, and the capping layer 130 may have a refractive index in a range of about 2.23 to about 2.43. In this case, the first thickness t1 of the capping layer 130 may be in a range of about 50 nm to about 95 nm. In embodiments, the wavelength of the light emitted by the light emitting structure 120 may be in a range of, for example, about 620 nm to about 700 nm, about 640 nm to about 680 nm, or about 650 nm to about 670 nm, and, for example, the target wavelength of the light emitted by the light emitting structure 120 may be 660 nm.

In some embodiments included in Group 2, the second semiconductor layer 126 may include an AlGaInP material, the third refractive index n0 may be in a range of about 3.45 to about 3.55, the second refractive index n2 of the encapsulation layer 140 may be in a range of about 1.35 to about 1.60, and the first refractive index n1 of the capping layer 130 may be in a range of about 2.05 to about 2.53. For example, based on the refractive index of the encapsulation layer 140 being 1.41, the target refractive index of the capping layer 130 may be 2.22, and in some embodiments, the capping layer 130 may have a refractive index in a range of about 2.05 to about 2.42, and the capping layer 130 may have a refractive index in a range of about 2.12 to about 2.32. In addition, based on the refractive index of the encapsulation layer 140 being 1.55, the target refractive index of the capping layer 130 may be 2.33, and in some embodiments, the capping layer 130 may have a refractive index in a range of about 2.13 to about 2.53, and the capping layer 130 may have a refractive index in a range of about 2.23 to about 2.43. In this case, the first thickness t1 of the capping layer 130 may be in a range of about 55 nm to about 100 nm. In embodiments, the wavelength of the light emitted by the light emitting structure 120 may be in a range of, for example, about 680 nm to about 750 nm, about 700 nm to about 750 nm, or about 720 nm to about 740 nm, and, for example, the target wavelength of the light emitted by the light emitting structure 120 may be 730 nm.

In some embodiments included in Group 3, the second semiconductor layer 126 may include an AlGaAs material, the third refractive index n0 may be in a range of about 3.60 to about 3.70, the second refractive index n2 of the encapsulation layer 140 may be in a range of about 1.35 to about 1.60, and the first refractive index n1 of the capping layer 130 may be in a range of about 2.07 to about 2.58. For example, based on the refractive index of the encapsulation layer 140 being 1.41, the target refractive index of the capping layer 130 may be 2.27, and in some embodiments, the capping layer 130 may have a refractive index in a range of about 2.07 to about 2.47, and the capping layer 130 may have a refractive index in a range of about 2.17 to about 2.37. In addition, based on the refractive index of the encapsulation layer 140 being 1.55, the target refractive index of the capping layer 130 may be 2.38, and in some embodiments, the capping layer 130 may have a refractive index in a range of about 2.18 to about 2.58, and the capping layer 130 may have a refractive index in a range of about 2.28 to about 2.48. In this case, the first thickness t1 of the capping layer 130 may be in a range of about 55 nm to about 100 nm. In embodiments, the wavelength of the light emitted by the light emitting structure 120 may be in a range of, for example, about 680 nm to about 750 nm, about 700 nm to about 750 nm, or about 720 nm to about 740 nm, and, for example, the target wavelength of the light emitted by the light emitting structure 120 may be 730 nm.

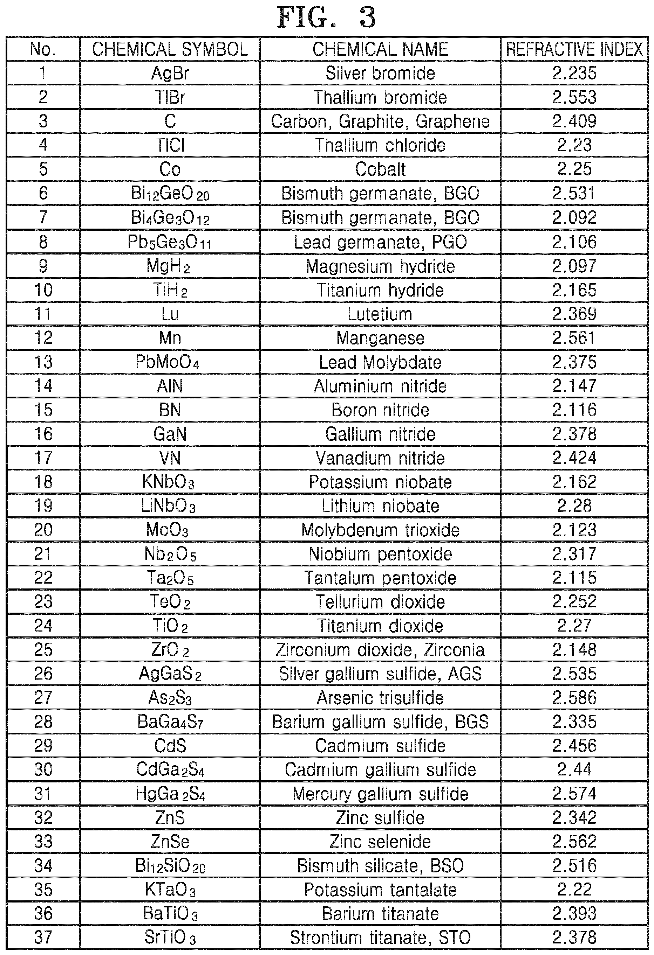

FIG. 3 is a table illustrating a material of the capping layer 130 and a refractive index corresponding thereto according to embodiments.

Referring to FIG. 3, the capping layer 130 may include at least one of AgBr, TlBr, C, TlCl, Co, $Bi_{12}GeO_{20}$, $Bi_4Ge_3O_{12}$, $Pb_5Ge_3O_{11}$, $MgH_2$, $TiH_2$, Lu, Mn, $PbMoO_4$, AlN, BN, GaN, $Si_3N_4$, VN, KNbOs, $LiNbO_3$, MoOs, $Nb_2O_5$, $Ta_2O_5$, $TeO_2$, $TiO_2$, $ZrO_2$, $AgGaS_2$, $As_2S_3$, $BaGaS_7$, CdS, $CdGa_2S_4$, $HgGa_2S_4$, ZnS, ZnSe, $Bi_{12}SiO_{20}$, $KTaO_3$, BaTiOa, and SrTiOa. As illustrated in FIG. 3, materials that may be included in the capping layer 130 may have the first refractive index n1 in the range of about 2.05 to about 2.58.

As described above with reference to FIGS. 1 and 2, the material, refractive index, and thickness of the capping layer 130 may be determined by the material and refractive index of the second semiconductor layer 126, and the material and refractive index of the encapsulation layer 140. For example, in accordance with the material and refractive index of the second semiconductor layer 126 and the material and refractive index of the encapsulation layer 140, the refractive index and material of the capping layer 130 may be determined based on the above Equation (1) and the thickness of the capping layer 130 may be determined based on the above Equation (2) by considering the range of the target wavelength of the light emitted by the light emitting structure 120.

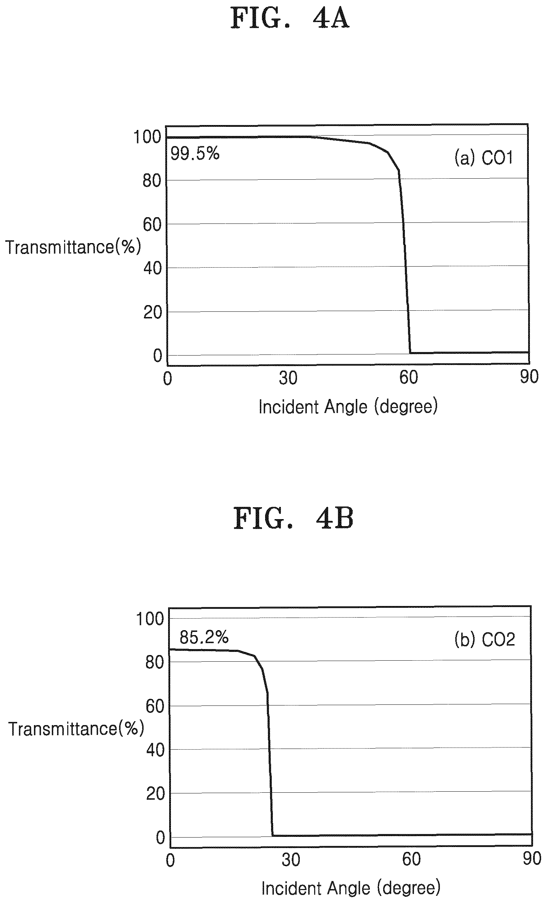

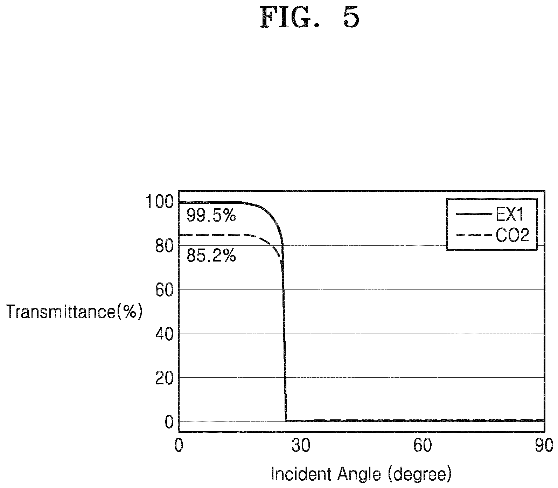

FIGS. 4A and 4B are simulation graphs illustrating transmittance of a semiconductor light emitting device according to Example 1 and Example 2, and FIG. 5 is a simulation graph illustrating transmittance of a semiconductor light emitting device according to an embodiment.

In FIG. 4A, transmittance according to an incident angle of blue light emitting device CO1 according to Example 1 is displayed, and in FIG. 4B, transmittance according to an incident angle of a red light emitting device CO2 according to Example 2 is displayed. The blue light emitting device CO1 according to Example 1 has a structure in which an encapsulation layer is arranged on a sapphire substrate. The red light emitting device CO2 according to Example 2 has a structure in which an encapsulation layer is directly arranged on a top surface of a light emitting structure (for example, an AlInGaP material), and does not include a capping layer (e.g., does not include the capping layer 130 discussed above).

The blue light emitting device CO1 according to Example 1 has relatively high transmittance of about 99.5 %. This may be because the sapphire substrate has a refractive index of about 1.78 and the encapsulation layer including a silicone resin has a refractive index of about 1.55, so that light reflection or light loss at an interface between the sapphire substrate and the silicone resin is insignificant. In contrast, in the red light emitting device CO2 according to Example 2, because the AlInGaP material has a refractive index in a range of about 3.49 to about 3.95 and the encapsulation layer including a silicon resin has a refractive index of about 1.55, a difference in refractive index at the interface between the AlInGaP material layer and a silicon resin may be in a range of about 1.9 to about 2.54. Therefore, due to the relatively large difference in refractive index at the interface, the red light emitting device CO2 according to Example 2 has relatively low transmittance of about 85.2 %.

Referring to FIG. 5, a red light emitting device EX1 according to embodiments has a structure described with reference to FIGS. 1 and 2 in which a capping layer (e.g. the capping layer 130) is arranged on a top surface of a light emitting structure (for example, an AlInGaP material) and an encapsulation layer is arranged on the capping layer. The red light emitting device EX1 according to embodiments has transmittance of 99.95 %, which is significantly increased compared to about 85.2 % of the red light emitting device CO2 according to Example 2, and is greater than or similar to that of the blue light emitting device CO1 according to Example 1.

Referring back to FIGS. 1 and 2, the semiconductor light emitting device 100 according to embodiments may include the capping layer 130 having the first refractive index n1 in the range of about 2.05 to about 2.58 and the first thickness t1 in the range of about 50 nm to about 100 nm between the light emitting structure 120 and the encapsulation layer 140 and may thus have high light extraction efficiency in the red wavelength range.

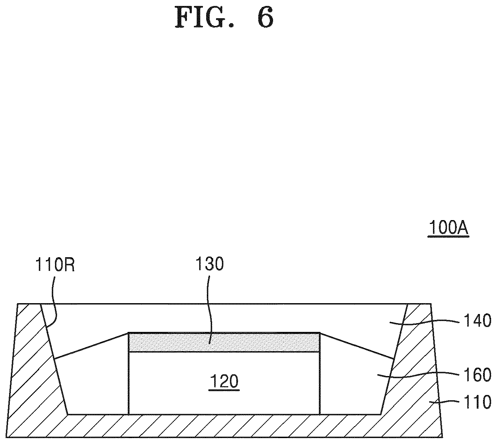

FIG. 6 is a cross-sectional view illustrating a semiconductor light emitting device 100A according to embodiments.

Referring to FIG. 6, a reflective layer 160may be arranged on or cover side walls of a light emitting structure 120, and may be arranged on a top surface of a housing 110. The capping layer 130 may be arranged on a top surface of the light emitting structure 120, and the reflective layer 160 may be arranged on or cover side walls of the capping layer 130.

In embodiments, the reflective layer 160 may include a resin material including highly reflective powder. In embodiments, the highly reflective powder may include metal powder such as aluminum (Al) or silver (Ag). In embodiments, the highly reflective powder may include ceramic powder, for example, at least one of $TiO_2$, $Al_2O_3$, $Nb_2O_5$, and ZnO. The resin material included in the reflective layer 160 may include a silicone resin, an epoxy resin, or a combination thereof.

The encapsulation layer 140 may be arranged on or cover a top surface of the reflective layer 160 and a top surface of the capping layer 130. Although FIG. 6 illustrates the encapsulation layer 140 as having a flat top surface at a same vertical level as a top surface of a side wall of the housing 110, embodiments are not limited thereto. For example, in embodiments, the top surface of the encapsulation layer 140 may convexly protrude upward from the top surface of the side wall of the housing 110.

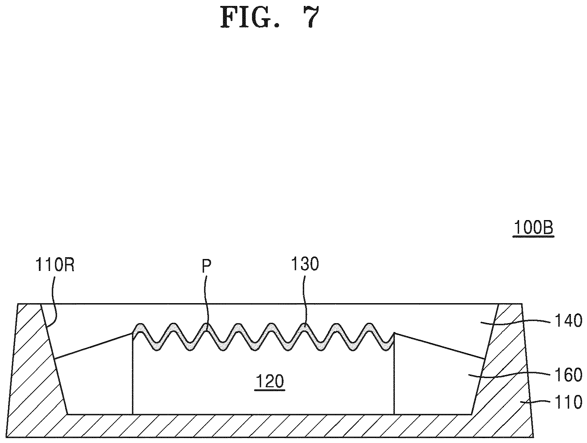

FIG. 7 is a cross-sectional view illustrating a semiconductor light emitting device 100B according to embodiments.

Referring to FIG. 7, a concavo-convex portion P may be provided on a top surface of a light emitting structure 120. A capping layer 130 may be conformally arranged on the top surface of the light emitting structure 120 along a shape of the concavo-convex portion P.

In embodiments, the concavo-convex portion P may increase the emission efficiency of red light emitted upward from a second semiconductor layer 126 toward an encapsulation layer 140 through the capping layer 130. In embodiments, the concavo-convex portion P may have a width in a range of about 100 nm to about 3 micrometers, and a height in a range of about 100 nm to about 3 $\mu$m. In embodiments, the concavo-convex portion P may be formed by removing an upper part of the second semiconductor layer 126 by a texturing process.

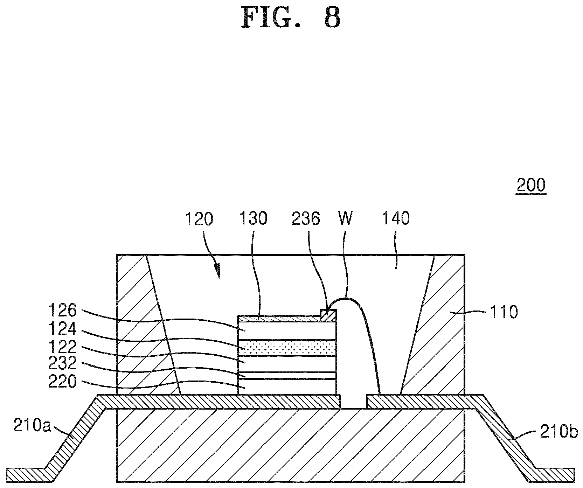

FIG. 8 is a cross-sectional view illustrating a semiconductor light emitting device 200 according to embodiments. In FIG. 8, the same reference numerals as in FIGS. 1 to 7 may denote the same components, and redundant or duplicative description may be omitted.

Referring to FIG. 8, a light emitting structure 120 may be mounted on lead frames 210a and 210b, a bottom surface of the light emitting structure 120 may be directly connected to the lead frame 210a, and a top surface of the light emitting structure 120 may be electrically connected to the lead frame 210b through a wire W. A housing 110 may be arranged on or cover at least a part of the lead frames 210a and 210b.

The housing 110 may have a cup-shaped groove, and the housing 110 may include a resin material including highly reflective powder. In other embodiments, the housing 110 may include a silicone resin or an epoxy resin including highly reflective metal powder or highly reflective ceramic powder.

As illustrated in FIG. 8, the light emitting structure 120 may include a substrate 220, a first electrode layer 232 arranged on the substrate 220, a first semiconductor layer 122 arranged on the first electrode layer 232, an active layer 124, and a second semiconductor layer 126.

The substrate 220 may include silicon, silicon carbide, gallium nitride, gallium arsenic, sapphire, $MgAl_2O_4$, MgO, $LiAlO_2$, and $LiGaO_2$. In some embodiments, the light emitting structure 120 may be grown on a growth substrate, and may be separated from the growth substrate and then attached onto the substrate 220. In other embodiments, the substrate 220 may be the growth substrate for forming the light emitting structure 120.

The first electrode layer 232 may be arranged between the substrate 220 and the first semiconductor layer 122. The first electrode layer 232 may include gold (Au), tin (Sn), titanium (Ti), nickel (Ni), or a combination thereof, and may reduce resistance between the substrate 220 and the first semiconductor layer 122. A second electrode layer 236 may be electrically connected to the second semiconductor layer 126. For example, the second electrode layer 236 may be arranged on the top surface of the light emitting structure 120. The second electrode layer 236 may include Au, Sn, Ti, Ni, or a combination thereof. As illustrated in FIG. 8, a capping layer 130 may be arranged on or cover side walls of the second electrode layer 236 on a top surface of the second semiconductor layer 126.

In embodiments, a transparent electrode layer may be between the first electrode layer 232 and the first semiconductor layer 122. The transparent electrode layer may include at least one of indium tin oxide (InSnO), zinc oxide (ZnO), indium zinc oxide (InZnO), tungsten-doped tin oxide (W-doped SnO), and fluorine-doped tin oxide (F-doped SnO). The transparent electrode layer may help spread current between the first semiconductor layer 122 and the first electrode layer 232.

An encapsulation layer 140 may be arranged on or cover the lead frames 210a and 210b, the light emitting structure 120, and the capping layer 130 on the housing 110.

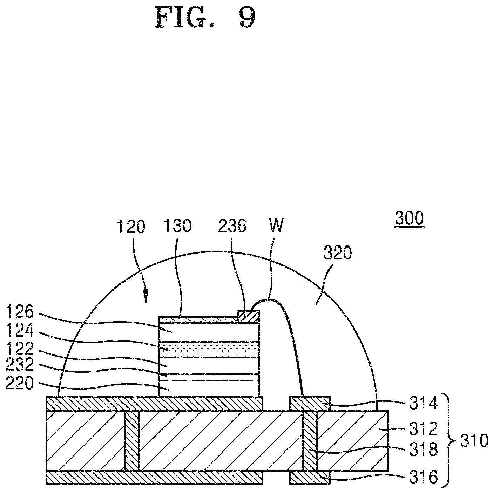

FIG. 9 is a cross-sectional view illustrating a semiconductor light emitting device 300 according to embodiments. In FIG. 9, the same reference numerals as in FIGS. 1 to 8 may denote the same components, and redundant or duplicative description may be omitted.

Referring to FIG. 9, a light emitting structure 120 may be mounted on a mounting substrate 310, and an encapsulation body 320 may be arranged on the mounting substrate 310, and may be arranged on or cover the light emitting structure 120 and a wire W.

The mounting substrate 310 may include a substrate body 312, an upper electrode 314, a lower electrode 316, and a through electrode 318. The substrate body 312 may include a resin, a ceramic, or a metal, and each of the upper electrode 314 and the lower electrode 316 may include a metal layer such as Au, copper (Cu), Ag, or Al. For example, the mounting substrate 310 may be provided as a substrate such as a printed circuit board (PCB), metal core PCB (MCPCB), metal PCB (MPCB), or flexible PCB (FPCB), and a structure of the mounting substrate 310 may be applied in various forms.

In some embodiments, as illustrated in FIG. 9, the encapsulation body 320 may include a dome-shaped lens structure with a convex top surface. However, in embodiments, it may be possible to adjust a beam angle of light emitted through the top surface of the encapsulation body 320 by forming a surface in a convex or concave lens structure.

The light emitting structure 120 may be mounted on the mounting substrate 310, a bottom surface of the light emitting structure 120 may be directly connected to the upper electrode 314 of the mounting substrate 310, and a top surface of the light emitting structure 120 may be electrically connected to the upper electrode 314 of the mounting substrate 310 through the wire W. A housing 110 may be arranged on or cover at least a part of the mounting substrate 310.

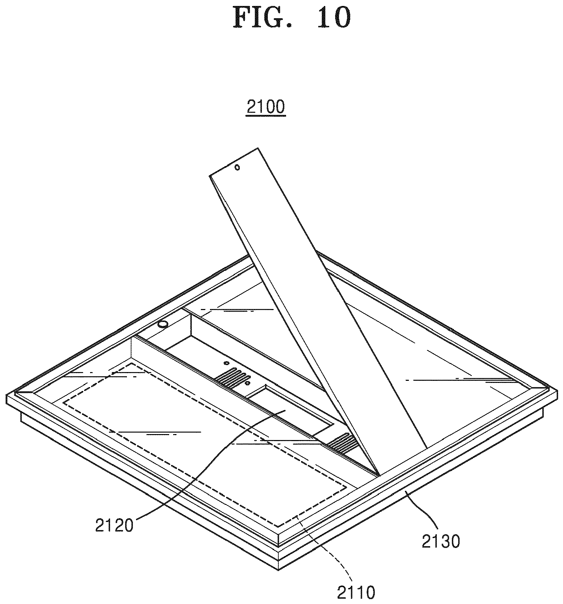

FIG. 10 is a perspective view schematically illustrating a flat panel lighting device 2100 including a semiconductor light emitting device according to embodiments.

Referring to FIG. 10, the flat panel lighting device 2100 may include a light source module 2110, a power supply 2120, and a housing 2130.

The light source module 2110 may include a light emitting device array as a light source, and may include at least one of the semiconductor light emitting devices described above as a light source. The light source module 2110 may form a flat surface as a whole.

The power supply 2120 may supply power to the light source module 2110. The housing 2130 may have an accommodation space so that the light source module 2110 and the power supply 2120 are accommodated therein, and may have a hexahedral shape open on one side. However, embodiments are not limited thereto. The light source module 2110 may be arranged to emit light to an open side surface of the housing 2130.

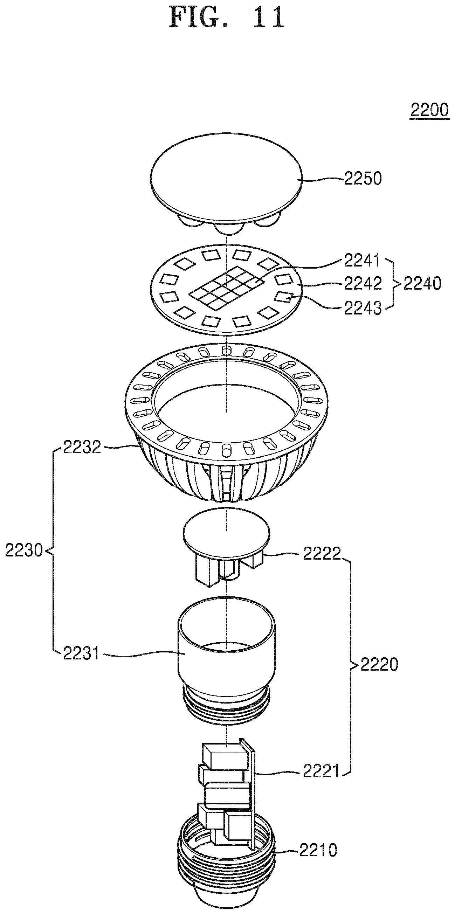

FIG. 11 is an exploded perspective view schematically illustrating a lighting device 2200 including a semiconductor light emitting device according to embodiments.

Referring to FIG. 11, the lighting device 2200 may include a socket 2210, a power supply 2220, a heat dissipation unit 2230, a light source module 2240, and an optical unit 2250.

The socket 2210 may be allow the lighting device 2200 to be replaceable with other lighting devices. Power supplied to the lighting device 2200 may be applied through the socket 2210. The power supply 2220 may be divided into a first power supply 2221 and a second power supply 2222 to be assembled. The heat dissipation unit 2230 may include an internal heat dissipation unit 2231 and an external heat dissipation unit 2232, and the internal heat dissipation unit 2231 may be directly connected to the light source module 2240 and/or the power supply 2220, so that heat may be transferred to the external heat dissipation unit 2232. The optical unit 2250 may include an internal optical unit and an external optical unit, and may be configured to evenly disperse light emitted by the light source module 2240.

The light source module 2240 may receive power from the power supply 2220 and may emit light to the optical unit 2250. The light source module 2240 may include one or more light emitting device packages 2241, a circuit board 2242, and controllers 2243, and the controllers 2243 may store driving information of the light emitting device packages 2241. The light emitting device packages 2241 may include at least one of the semiconductor light emitting devices described above.

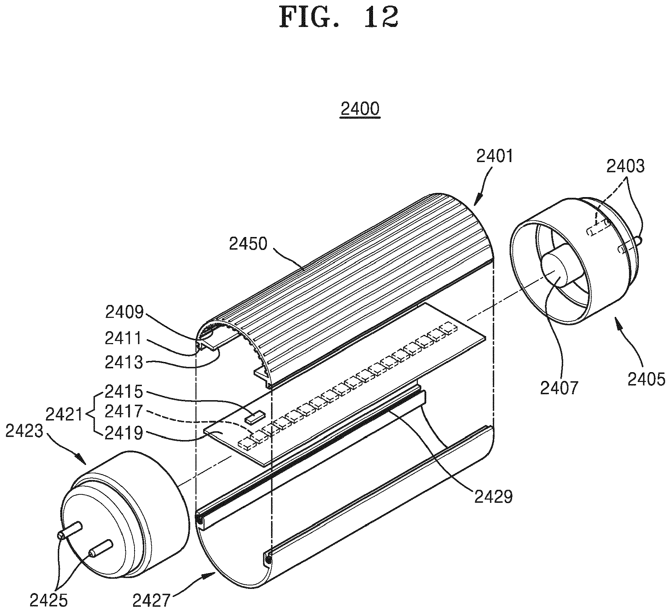

FIG. 12 is an exploded perspective view schematically illustrating a bar type lighting device 2400 including a semiconductor light emitting device according to embodiments.

For example, the bar type lighting device 2400 may include a heat dissipation member 2401, a cover 2427, a light source module 2421, a first socket 2405, and a second socket 2423. A plurality of heat dissipation fins 2450 and 2409 may be formed in a concavo-convex shape on an internal and/or external surface of the heat dissipation member 2401, and the plurality of heat dissipation fins 2450 and 2409 may be designed to have various shapes and intervals. Protruding supports 2413 are formed in the heat dissipation member 2401. The light source module 2421 may be fixed to the protruding supports 2413. Locking jaws 2411 may be formed at both ends of the heat dissipation member 2401.

Locking grooves 2429 may be formed in the cover 2427, and the locking jaws 2411 of the heat dissipation member 2401 may be coupled to the locking grooves 2429 in a hook coupling structure. Positions at which the locking grooves 2429 and the locking jaws 2411 are formed may be interchanged.

The light source module 2421 may include a PCB 2419, a light source 2417, and a controller 2415. The controller 2415 may store driving information of the light source 2417. Circuit wires for operating the light source 2417 may be formed on the PCB 2419. In addition, components for operating the light source 2417 may be included. The light source 2417 may include at least one of the semiconductor light emitting devices described above.

The first and second sockets 2405 and 2423 as a pair of sockets may be coupled to both ends of a cylindrical cover unit including the heat dissipation member 2401 and the cover 2427. For example, the first socket 2405 may include electrode terminals 2403 and a power supply 2407, and dummy terminals 2425 may be arranged in the second socket 2423. In addition, an optical sensor and/or a communication module may be embedded in either the first socket 2405 or the second socket 2423.

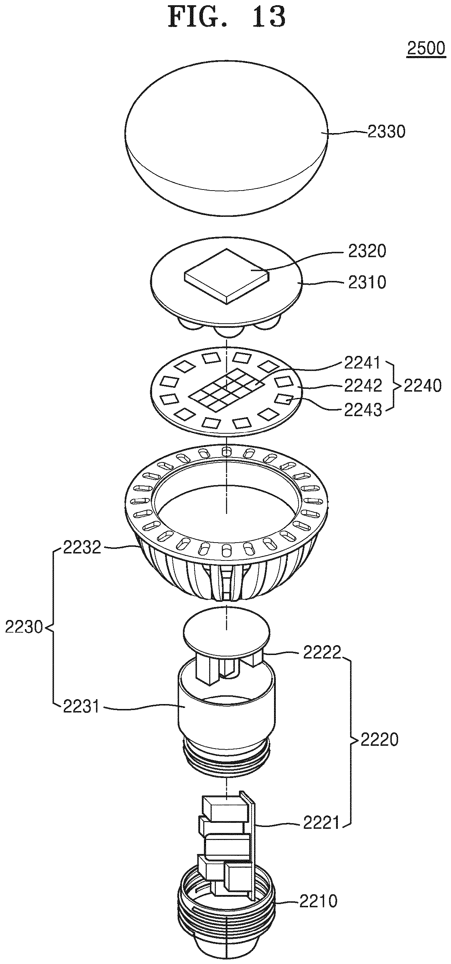

FIG. 13 is an exploded perspective view schematically illustrating a lighting device 2500 including a semiconductor light emitting device according to embodiments.

Specifically, the lighting device 2500 and the lighting device 2200 described above may differ in that a reflector 2310 and a communication module 2320 may be provided on a light source module 2240. The reflector 2310 may reduce glare by evenly spreading light from a light source to a side and back.

The communication module 2320 may be mounted on the reflector 2310, and home-network communication may be implemented using the communication module 2320. For example, the communication module 2320 may include a wireless communication module using Zigbee, WiFi, or LiFi, and may control lighting devices installed inside and outside the home, such as turning on/off and adjusting brightness of the lighting devices, or may control electronic products and automobile systems inside and outside the home, such as a TV, a refrigerator, an air conditioner, a door lock, and an automobile through a smartphone or a wireless controller. The reflector 2310 and the communication module 2320 may be covered with a cover 2330.

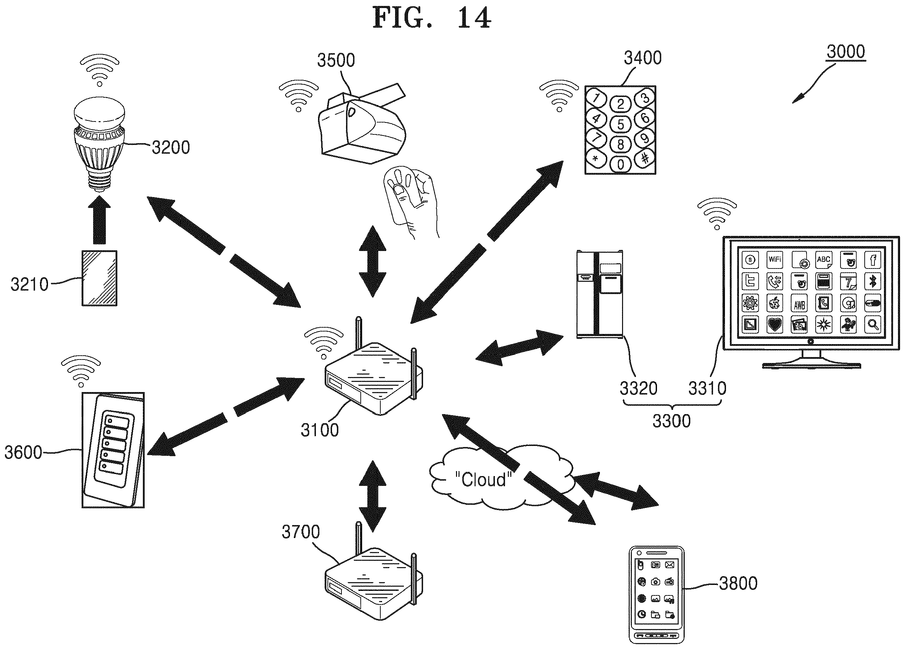

FIG. 14 is a schematic diagram illustrating an indoor lighting control network system 3000 including a semiconductor light emitting device according to embodiments.

In embodiments, the indoor lighting control network system 3000 may include a complex smart lighting-network system, in which lighting technology using light emitting devices such as light emitting diodes (LED), Internet of Things (IoT) technology, and wireless communication technology are converged. The indoor lighting control network system 3000 may be implemented using various lighting devices and wired/wireless communication devices, or may be implemented based on an IoT environment to collect/process various information items and provide the information items to users.

An LED lamp 3200 included in the indoor lighting control network system 3000 may check and control operating states of other devices (for example a plurality of devices 3300 to 3800) included in the IoT environment based on functions such as visible light communication of the LED lamp 3200, and also may receive information about a surrounding environment from a gateway 3100 to control lighting of the LED lamp 3200. The LED lamp 3200 may include at least one of the semiconductor light emitting devices described above. The LED lamp 3200 may be communicatively connected to the gateway 3100 by a wireless communication protocol such as WiFi, Zigbee, or LiFi, and may have at least one lamp communication module 3210 for this purpose.

When the indoor lighting control network system 3000 is applied to a home, the plurality of devices 3300 to 3800 may include a home appliance device 3300, a digital door lock device 3400, a garage door lock device 3500, a lighting switch device 3600 which may be installed on a wall, a router device 3700 which may be used as a wireless communication network relay, and a mobile device 3800 such as a smartphone, a tablet, or a laptop computer.

In the indoor lighting control network system 3000, the LED lamp 3200 may check the operating states of the plurality of devices 3300 to 3800 using a wireless communication network (Zigbee, WiFi, or LiFi) installed in the home, or may automatically adjust illumination of the LED lamp 3200 according to a surrounding environment/situation. In addition, the plurality of devices 3300 to 3800 included in the indoor lighting control network system 3000 may be controlled by using LiFi communication using visible light emitted by the LED lamp 3200.

For example, the LED lamp 3200 may automatically adjust the illumination of the LED lamp 3200 based on the surrounding environment transmitted from the gateway 3100 through the lamp communication module 3210 or surrounding environment information collected from a sensor mounted on the LED lamp 3200. For example, the lighting brightness of the LED lamp 3200 may be automatically adjusted according to the type of program broadcast on a television 3310 or brightness of a screen. To this end, the LED lamp 3200 may receive operation information of the television 3310 from the lamp communication module 3210 connected to the gateway 3100. The lamp communication module 3210 may be integrally modularized with a sensor and/or a controller included in the LED lamp 3200.

For example, when a predetermined time elapses after the digital door lock device 3400 is locked without a person in the home, the turned-on LED lamp 3200 may be turned off to prevent waste of electricity. As another example, in a case in which a security mode is set through the mobile device 3800, when the digital door lock device 3400 is locked without a person in the home, the LED lamp 3200 may be kept turned on.

An operation of the LED lamp 3200 may be controlled according to the surrounding environment collected through various sensors connected to the indoor lighting control network system 3000. For example, when the indoor lighting control network system 3000 is implemented in a building, by combining lighting, location sensors, and communication modules in the building, and collecting location information of people in the building, the lighting may be turned on or off, or the collected information may be displayed in real time to enable facility management and efficient use of idle spaces.

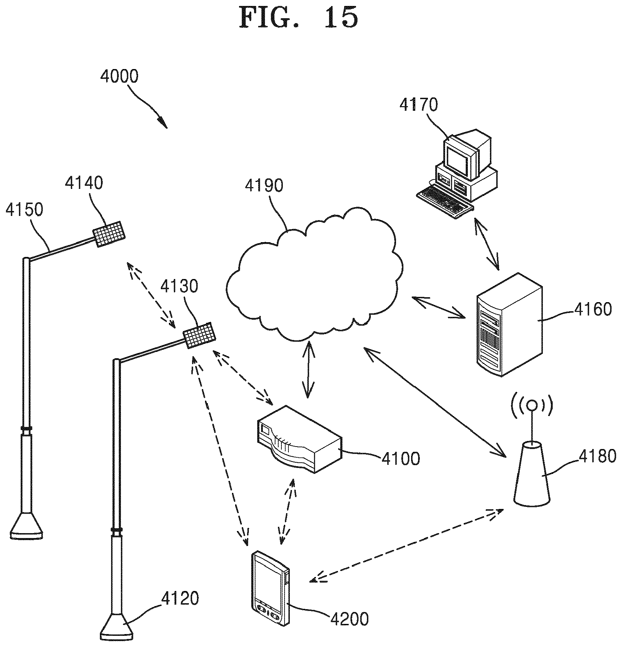

FIG. 15 is a schematic diagram illustrating a network system 4000 including a semiconductor light emitting device according to embodiments.

For example, FIG. 15 illustrates an embodiment of the network system 4000 applied to an open space. The network system 4000 may include a communication connection device 4100, a plurality of lighting fixtures 4120 and 4150 installed at predetermined intervals and communicatively connected to the communication connection device 4100, a server 4160, a computer 4170 for managing the server 4160, a communication base station 4180, a communication network 4190 connecting communication devices, and a mobile device 4200.

The plurality of lighting fixtures 4120 and 4150 installed in an open outdoor space such as a street or a park may include smart engines 4130 and 4140, respectively. Each of the smart engines 4130 and 4140 may include a sensor for collecting the surrounding environment information and a communication module as well as a light emitting device for emitting light and a driver for driving the light emitting device. The light emitting device included in a smart engine may include at least one of the semiconductor light emitting devices described above.

Using the communication module, the smart engines 4130 and 4140 may communicate with other surrounding devices according to a communication protocol such as WiFi, Zigbee, or LiFi. The smart engine 4130 may be communicatively connected to the smart engine 4140, and WiFi expansion technology (WiFi Mesh) may be applied to communication between the smart engines 4130 and 4140. At least one smart engine, for example the smart engine 4130, may be connected to the communication connection device 4100 connected to the communication network 4190 through wired/wireless communication.

The communication connection device 4100 may be an access point (AP) capable of wired/wireless communication, and may mediate communication between the communication network 4190 and other equipment. The communication connection device 4100 may be connected to the communication network 4190 by at least one of wired/wireless methods, and may be mechanically accommodated in any one of the plurality of lighting fixtures 4120 and 4150, for example.

The communication connection device 4100 may be connected to the mobile device 4200 through a communication protocol such as WiFi. A user of the mobile device 4200 may receive the surrounding environment information collected by the plurality of smart engines 4130 and 4140, for example, surrounding traffic information and weather information through the communication connection device 4100 connected to the smart engine 4130 of the neighboring lighting fixture 4120. The mobile device 4200 may be connected to the communication network 4190 through the communication base station 4180 by a wireless cellular communication method such as 3G or 4G.

In embodiments, the server 4160 connected to the communication network 4190 may receive the information collected by the smart engines 4130 and 4140 mounted on each of the plurality of lighting fixtures 4120 and 4150, and may monitor the operating states of the plurality of lighting fixtures 4120 and 4150. The server 4160 may be connected to the computer 4170 providing a management system, and the computer 4170 may execute software that may monitor and manage the operating states of the smart engines 4130 and 4140.

While some embodiments have been particularly shown and described, it will be understood that various changes in form and details may be made therein without departing from the spirit and scope of the following claims.

**Claims**

**1.** A semiconductor light emitting device comprising:

a light emitting structure comprising a first semiconductor layer having a first conductivity type, a second semiconductor layer having a second conductivity type which is different from the first conductivity type, and an active layer between the first semiconductor layer and the second semiconductor layer and configured to emit light having a wavelength in a range of about 620 nm to about 750 nm;

a first electrode electrically connected to the first semiconductor layer;

a second electrode electrically connected to the second semiconductor layer;

a capping layer on a top surface of the light emitting structure and having a first refractive index in a range of about 2.05 to about 2.58; and

an encapsulation layer on the capping layer and on the light emitting structure, and having a second refractive index which is less than the first refractive index.

2. The semiconductor light emitting device of claim 1, wherein the capping layer comprises at least one of silver bromide (AgBr), thallium bromide (TlBr), carbon (C), thallium chloride (TlCl), cobalt (Co), bismuth germanate ($Bi_{12}GeO_{20}$), bismuth germanate ($Bi_4Ge_3O_{12}$), lead germanate ($Pb_5Ge_3O_{11}$), magnesium hydroxide ($MgH_2$), titanium hydroxide ($TiH_2$), lutetium (Lu), manganese (Mn), lead molybdic acid ($PbMoO_4$), aluminum nitride (AlN), boron nitride (BN), gallium nitride (GaN), silicon nitride ($Si_3N_4$), vanadium nitride (VN), potassium niobate ($KNbO_3$), lithium niobate ($LiNbO_3$), molybdenum trioxide (MoOs), niobium pentoxide ($Nb_2O_5$), tantalum pentoxide ($Ta_2O_5$), tellurium dioxide ($TeO_2$), titanium oxide ($TiO_2$), zirconium oxide ($ZrO_2$), silver gallium sulfide ($AgGaS_2$), arsenic trisulfide ($As_2S_3$), barium gallium sulfide ($BaGaS_7$), cadmium sulfide (CdS), cadmium gallium sulfide ($CdGa_2S_4$), mercury gallium sulfide ($HgGa_2S_4$), zinc sulfide (ZnS), zinc selenium (ZnSe), bismuth silicate ($Bi_{12}SiO_{20}$), potassium tantalate ($KTaO_3$), barium titanate ($BaTiO_3$), and strontium titanate (SrTiOa).

3. The semiconductor light emitting device of claim 1, wherein the second refractive index is in a range of about 1.35 to about 1.60, and

wherein a thickness of the capping layer is in a range of about 50 nm to about 100 nm.

4. The semiconductor light emitting device of claim 1, wherein the capping layer is on a top surface of the second semiconductor layer,

wherein the second semiconductor layer comprises $Al_xGa_yIn_{1-y}P$ (where $0 \leq x \leq 1$, $0 \leq y \leq 1$, and $0 \leq x+y \leq 1$),

wherein the second semiconductor layer has a third refractive index which is greater than the first refractive index, and

wherein the third refractive index is in a range of about 3.45 to about 3.55.

5. The semiconductor light emitting device of claim 4, wherein the light emitted by the light emitting structure has a target wavelength of 660 nm,

wherein a thickness of the capping layer is in a range of about 50 nm to about 95 nm, and

wherein the first refractive index is in a range of about 2.05 to about 2.53.

6. The semiconductor light emitting device of claim 5, wherein the first refractive index is in a range of about 2.12 to about 2.43.

7. The semiconductor light emitting device of claim 4, wherein the light emitted by the light emitting structure has a target wavelength of 730 nm,

wherein a thickness of the capping layer is in a range of about 55 nm to about 100 nm, and

wherein the first refractive index is in a range of about 2.05 to about 2.53.

8. The semiconductor light emitting device of claim 7, wherein the first refractive index is in a range of about 2.12 to about 2.43.

9. The semiconductor light emitting device of claim 1, wherein the capping layer is on a top surface of the second semiconductor layer,

wherein the second semiconductor layer comprises $Al_xGa_{1-x}As$ (where $0 \leq x \leq 1$),

wherein the second semiconductor layer has a third refractive index which is greater than the first refractive index, and

wherein the third refractive index is in a range of about 3.60 to about 3.70.

10. The semiconductor light emitting device of claim 9, wherein a the light emitted by the light emitting structure has a target wavelength of 730 nm,

wherein a thickness of the capping layer is in a range of about 55 nm to about 100 nm, and
wherein the first refractive index is in a range of about 2.07 to about 2.58.

11. The semiconductor light emitting device of claim 10, wherein the first refractive index is in a range of about 2.17 to about 2.48.

12. The semiconductor light emitting device of claim 1, further comprising:

a housing, wherein the light emitting structure is mounted on a top surface of the housing; and
a reflective layer on side surfaces of the light emitting structure ,
wherein the encapsulation layer is on a top surface of the capping layer and a top surface of the reflective layer.

13. The semiconductor light emitting device of claim 12, wherein the encapsulation layer comprises a silicon resin, and wherein the encapsulation layer does not include a phosphor.

14. The semiconductor light emitting device of claim 1, wherein a top surface of the second semiconductor layer comprises a concavo-convex portion, and
wherein the capping layer is conformally arranged on the concavo-convex portion.

# FIG. 1

# FIG. 2

# FIG. 3

| No. | CHEMICAL SYMBOL | CHEMICAL NAME | REFRACTIVE INDEX |
|---|---|---|---|
| 1 | AgBr | Silver bromide | 2.235 |
| 2 | TlBr | Thallium bromide | 2.553 |
| 3 | C | Carbon, Graphite, Graphene | 2.409 |
| 4 | TlCl | Thallium chloride | 2.23 |
| 5 | Co | Cobalt | 2.25 |
| 6 | $Bi_{12}GeO_{20}$ | Bismuth germanate, BGO | 2.531 |
| 7 | $Bi_4Ge_3O_{12}$ | Bismuth germanate, BGO | 2.092 |
| 8 | $Pb_5Ge_3O_{11}$ | Lead germanate, PGO | 2.106 |
| 9 | $MgH_2$ | Magnesium hydride | 2.097 |
| 10 | $TiH_2$ | Titanium hydride | 2.165 |
| 11 | Lu | Lutetium | 2.369 |
| 12 | Mn | Manganese | 2.561 |
| 13 | $PbMoO_4$ | Lead Molybdate | 2.375 |
| 14 | AlN | Aluminium nitride | 2.147 |
| 15 | BN | Boron nitride | 2.116 |
| 16 | GaN | Gallium nitride | 2.378 |
| 17 | VN | Vanadium nitride | 2.424 |
| 18 | $KNbO_3$ | Potassium niobate | 2.162 |
| 19 | $LiNbO_3$ | Lithium niobate | 2.28 |
| 20 | $MoO_3$ | Molybdenum trioxide | 2.123 |
| 21 | $Nb_2O_5$ | Niobium pentoxide | 2.317 |
| 22 | $Ta_2O_5$ | Tantalum pentoxide | 2.115 |
| 23 | $TeO_2$ | Tellurium dioxide | 2.252 |
| 24 | $TiO_2$ | Titanium dioxide | 2.27 |
| 25 | $ZrO_2$ | Zirconium dioxide, Zirconia | 2.148 |
| 26 | $AgGaS_2$ | Silver gallium sulfide, AGS | 2.535 |
| 27 | $As_2S_3$ | Arsenic trisulfide | 2.586 |
| 28 | $BaGa_4S_7$ | Barium gallium sulfide, BGS | 2.335 |
| 29 | CdS | Cadmium sulfide | 2.456 |
| 30 | $CdGa_2S_4$ | Cadmium gallium sulfide | 2.44 |
| 31 | $HgGa_2S_4$ | Mercury gallium sulfide | 2.574 |
| 32 | ZnS | Zinc sulfide | 2.342 |
| 33 | ZnSe | Zinc selenide | 2.562 |
| 34 | $Bi_{12}SiO_{20}$ | Bismuth silicate, BSO | 2.516 |
| 35 | $KTaO_3$ | Potassium tantalate | 2.22 |
| 36 | $BaTiO_3$ | Barium titanate | 2.393 |
| 37 | $SrTiO_3$ | Strontium titanate, STO | 2.378 |

# FIG. 4A

# FIG. 4B

# FIG. 5

# FIG. 6

100A

110R  130

140

120

160

110

# FIG. 7

# FIG. 8

200

120  130  236  W  140

126
124
122
232
220

210a

110

210b

# FIG. 9

# FIG. 10

2100

2120

2130

2110

# FIG. 11

2200

2250

2241
2242  } 2240
2243

2232
2230
2231

2222
2220
2221

2210

# FIG. 12

2400

# FIG. 13

# FIG. 14

FIG. 15

Europäisches
Patentamt

European
Patent Office

Office européen
des brevets

# EUROPEAN SEARCH REPORT

Application Number

EP 23 21 9119

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | KR 2013 0105772 A (LG INNOTEK CO LTD [KR]) 26 September 2013 (2013-09-26) * paragraphs [0033], [0036], [0040] - [0042], [0106]; figures 5,6 * ----- | 1-14 | INV. H01L33/44 H01L33/56 |
| X | US 2013/113007 A1 (CHOI WOON KYUNG [KR]) 9 May 2013 (2013-05-09) * paragraphs [0028], [0056]; figure 1 * ----- | 1,14 | |
| X | KR 101 795 038 B1 (LG INNOTEK CO LTD [KR]) 7 November 2017 (2017-11-07) * paragraphs [0034] - [0036]; figures 1,21 * ----- | 1,14 | |
| X | US 2015/091037 A1 (JUNG SUNG HO [KR] ET AL) 2 April 2015 (2015-04-02) * paragraphs [0066], [0101], [0105]; figures 1-4 * ----- | 1,14 | |

TECHNICAL FIELDS
SEARCHED       (IPC)

H01L

The present search report has been drawn up for all claims

| Place of search | Date of completion of the search | Examiner |
|---|---|---|
| The Hague | 17 May 2024 | Chin, Patrick |

CATEGORY OF CITED DOCUMENTS

X : particularly relevant if taken alone
Y : particularly relevant if combined with another
     document of the same category
A : technological background
O : non-written disclosure
P : intermediate document

T : theory or principle underlying the invention
E : earlier patent document, but published on, or
     after the filing date
D : document cited in the application
L : document cited for other reasons

& : member of the same patent family, corresponding
     document

EPO FORM 1503 03.82 (P04C01)

## ANNEX TO THE EUROPEAN SEARCH REPORT
## ON EUROPEAN PATENT APPLICATION NO.

EP 23 21 9119

This annex lists the patent family members relating to the patent documents cited in the above-mentioned European search report.
The members are as contained in the European Patent Office EDP file on
The European Patent Office is in no way liable for these particulars which are merely given for the purpose of information.

17-05-2024

| Patent document cited in search report | | Publication date | Patent family member(s) | | Publication date |
|---|---|---|---|---|---|
| KR 20130105772 | A | 26-09-2013 | NONE | | |
| US 2013113007 | A1 | 09-05-2013 | EP 2590235 | A1 | 08-05-2013 |
| | | | JP 6104568 | B2 | 29-03-2017 |
| | | | JP 2013102162 | A | 23-05-2013 |
| | | | KR 20130050060 | A | 15-05-2013 |
| | | | US 2013113007 | A1 | 09-05-2013 |
| KR 101795038 | B1 | 07-11-2017 | NONE | | |
| US 2015091037 | A1 | 02-04-2015 | CN 104518064 | A | 15-04-2015 |
| | | | EP 2858128 | A1 | 08-04-2015 |
| | | | KR 20150039518 | A | 10-04-2015 |
| | | | US 2015091037 | A1 | 02-04-2015 |

EPO FORM P0459

For more details about this annex : see Official Journal of the European Patent Office, No. 12/82

**EP 4 394 904 A1**

## REFERENCES CITED IN THE DESCRIPTION

**Patent documents cited in the description**

- KR 1020220187751